(19) Europäisches Patentamt

European Patent Office

Office européen des brevets

(11) EP 1 363 133 A2

(12) DEMANDE DE BREVET EUROPEEN

(43) Date de publication:
19.11.2003 Bulletin 2003/47

(51) Int Cl.⁷: G01R 31/36

(21) Numéro de dépôt: 03291144.8

(22) Date de dépôt: 16.05.2003

(84) Etats contractants désignés:
AT BE BG CH CY CZ DE DK EE ES FI FR GB GR HU IE IT LI LU MC NL PT RO SE SI SK TR
Etats d'extension désignés:
AL LT LV MK

(30) Priorité: 16.05.2002 FR 0206039

(71) Demandeur: Renault s.a.s.
92100 Boulogne Billancourt (FR)

(72) Inventeurs:
• Bogel, Wolfgang
  75014 Paris (FR)
• Soucaze Guillous, Benoît
  64000 Pau (FR)
• Hiron, Christian
  78690 Les Essarts (FR)

(54) **Procédé de mesure de l'état de charge d'une batterie d'accumulateurs electriques**

(57) Suivant ce procédé, a) à partir d'une tension ($U_f$) prédéterminée établie aux bornes de la batterie, on charge et on décharge ladite batterie à des tensions prédéterminées ($U_f + \Delta U_{f1}$) et ($U_f - \Delta U_{f2}$) respectivement, pendant des temps prédéterminés ($t_c$) et ($t_d$) respectivement, b) à l'expiration des temps ($t_c$) et ($t_d$), on mesure les courants ($i_c$) et ($i_d$), de charge et de décharge, respectivement, et c) on tire l'état de charge (EDC) de ladite batterie d'une relation préétablie liant $\text{Log}\frac{i_d}{i_c}$ audit état de charge (EDC).

FIG.:1

EP 1 363 133 A2

## Description

La présente invention est relative à un procédé de mesure de l'état de charge d'une batterie d'accumulateurs électriques.

Un véhicule automobile propulsé par un moteur à combustion interne comporte classiquement une telle batterie pour l'alimentation de divers appareils électriques du véhicule, notamment du démarreur électrique du moteur. La capacité du démarreur à lancer la rotation du moteur est directement liée à l'état de charge de la batterie qui l'alimente. Une charge insuffisante empêche tout démarrage du moteur. Il est donc important de pouvoir mesurer cet état de charge de manière à déterminer quand la batterie a besoin d'être rechargée.

Divers procédés de mesure de l'état de charge (EDC) d'une batterie ont donc été proposés. Selon un premier groupe de procédés, on mesure la tension électrique disponible aux bornes de la batterie ou la concentration en acide sulfurique (pour les batteries les plus courantes) de l'électrolyte qu'elle contient, cette tension ou cette concentration étant une image de l'état de charge de la batterie. Les mesures obtenues souffrent cependant souvent d'imprécisions dues à l'usure de la batterie, ou à la non prise en compte de la température de l'électrolyte, ou encore à un défaut d'homogénéité de l'électrolyte au moment de la mesure. On pourrait remédier à ce dernier défaut en procédant à la mesure après écoulement d'un temps d'homogénéisation de l'électrolyte mais celui-ci est long (24 heures environ).

Selon un autre groupe de procédés, on mesure l'impédance de la batterie mais cette mesure n'est vraiment représentative de l'état de charge de cette batterie que lorsque celle-ci est très déchargée.

Selon un troisième groupe de procédés, on évalue l'état de charge à partir de mesures dynamiques de tension, de courant et, éventuellement, de température.

Les procédés proposés pêchent cependant par divers défauts. C'est ainsi que certains (cf. US 6 037 749 ou US 5 726 553) font appel à des modèles de comportement de la batterie ou à des stratégies de mesure qui sont liés au type et/ou à la taille de la batterie. Or, dans un véhicule automobile, notamment, la batterie est remplacée plusieurs fois pendant la durée de vie utile du véhicule. Si lors d'un remplacement, la batterie nouvelle est d'un type différent de celui de la batterie pour laquelle le modèle ou la stratégie de mesure a été établi, il n'est plus possible d'obtenir une mesure fiable de l'état de charge de la batterie.

D'autres procédés proposés sont complexes et donc de mise en oeuvre coûteuse (voir US 6 144 185) ou ne prennent pas en compte l'influence de la température (US 6 236 189) ou bien encore ne sont pas suffisamment "robustes" au vieillissement de la batterie (US 5 130 659).

La présente invention a donc pour but de fournir un procédé de mesure de l'état de charge d'une batterie d'accumulateurs électriques qui ne présente pas ces inconvénients et qui, en particulier, soit de mise en oeuvre simple et peu onéreuse, largement dégagée des contraintes évoquées ci-dessus en matière de temps de repos, d'état de vieillissement, de température, de taille et de type de la batterie.

On atteint ce but de l'invention ainsi que d'autres qui apparaîtront à la lecture de la description qui va suivre, avec un procédé de mesure de l'état de charge d'une batterie d'accumulateur électrique, suivant lequel :

a) à partir d'une tension $U_f$ prédéterminée établie aux bornes de la batterie, on charge et on décharge ladite batterie à des tensions prédéterminées $U_f + \Delta U_{f1}$ et $U_f - \Delta U_{f2}$ respectivement, pendant des temps prédéterminés $t_c$ et $t_d$ respectivement,

b) à l'expiration des temps $t_c$ et $t_d$, on mesure les courants $i_c$ et $i_d$, de charge et de décharge, respectivement, et

c) on tire l'état de charge (EDC) de ladite batterie d'une relation préétablie liant $\mathrm{Log}\frac{i_d}{i_c}$ audit état de charge EDC.

Comme on le verra plus loin en détail, en mesurant ainsi simplement la faculté qu'a la batterie de se charger ou de se décharger en fonction d'un niveau de tension imposé, on détermine aisément l'état de charge de la batterie en se basant sur la faculté des électrodes de la batterie à accepter ou non une charge ou une décharge en courant.

Selon un mode de mise en oeuvre du procédé suivant l'invention, on procède d'abord à la charge, puis à la décharge de ladite batterie. La relation $\mathrm{Log}\frac{i_d}{i_c} = f$ (EDC) est établie pour diverses valeurs de la température de la batterie.

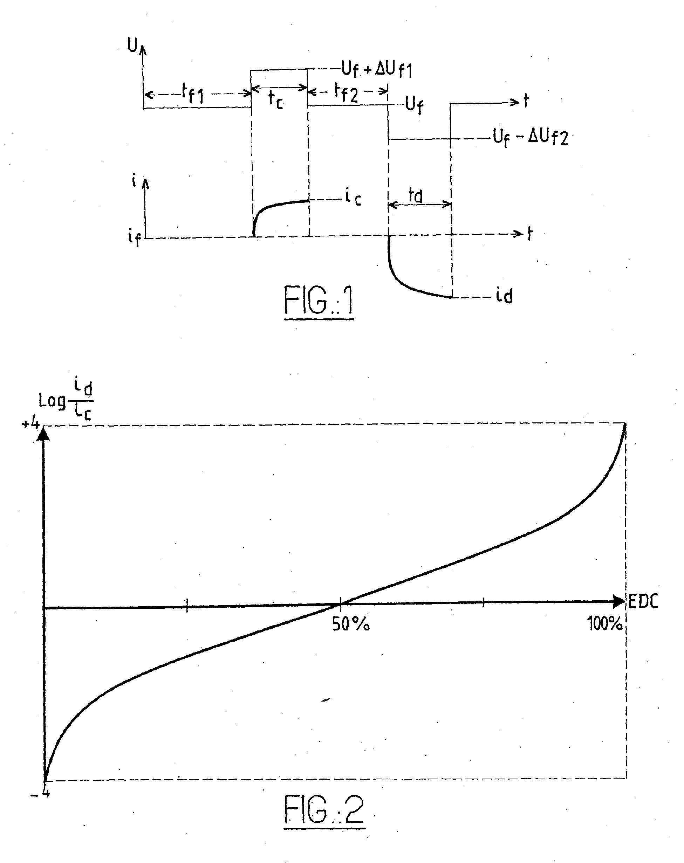

D'autres caractéristiques et avantages de la présente invention apparaîtront à la lecture de la description qui va suivre et à l'examen du dessin annexé dans lequel les figures 1 et 2 sont des graphes utiles à la description du procédé suivant l'invention.

On se réfère à la figure 1 du dessin annexé où l'un des graphes (U) représentés correspond à une séquence de tensions appliquées, conformément au procédé suivant l'invention, à une batterie d'accumulateurs dont on désire mesurer l'état de charge EDC. L'autre graphe (i) représente, en trait plein, les intensités du courant absorbé ou débité par la batterie, pendant deux phases de cette séquence.

On commence par appliquer à la batterie une tension $U_f$, choisie pour assurer une charge légère de la batterie.

A titre d'exemple illustratif et non limitatif, pour une batterie classique au plomb et à l'acide sulfurique, d'une tension nominale de 12 volts, telle que celle utilisée couramment dans un véhicule automobile pour démarrer un moteur à combustion interne, on peut choisir $U_f$ = 13 volts sachant qu'une batterie complètement chargée atteint 12,8 volts et qu'une batterie est complètement déchargée quand elle descend à 11,8 volts. La tension $U_f$ est alors dite de "floating" ou "d'entretien".

La tension $U_f$ est appliquée pendant un temps $t_{f1}$ suffisant pour assurer la montée à cette valeur de la tension disponible aux bornes de la batterie, en circuit ouvert.

Le temps $t_{f1}$ est ordinairement de l'ordre de quelques secondes, en tout cas inférieur à une minute.

Le temps $t_{f1}$ étant écoulé, on applique à la batterie une tension plus élevée $U_f + \Delta U_{f1}$, pendant un temps $t_c$.

Toujours à titre d'exemple, dans le cas de la batterie classique évoquée ci-dessus, on peut choisir $\Delta U_{f1}$=0,5 volts et $t_c$ = 1 seconde.

La batterie se charge alors avec un courant $i$ qui évolue comme représenté en trait plein à la figure 1, pour arriver à la fin du temps $t_c$ à la valeur $i_c$, qui est mesurée.

On décharge ensuite légèrement la batterie en ramenant la tension à ses bornes à la valeur $U_f$ antérieure au temps $t_c$, et ceci jusqu'à ce que le courant de décharge revienne lui aussi à sa valeur $i_f$ antérieure au temps $t_c$.

On peut choisir $t_{f2}$=$t_{f1}$ pour obtenir ce résultat, mais $t_{f2}$ pourrait aussi différer de $t_{f1}$.

Après cela on décharge encore légèrement la batterie, pendant un temps $t_d$, sous une tension $U_f$-$\Delta U_{f2}$, et on mesure le courant de décharge $i_d$ à la fin d'un temps $t_d$. $\Delta U_{f2}$ et $t_d$ peuvent être égaux à $\Delta U_{f1}$ et $t_c$, respectivement, mais peuvent être aussi différents, comme on le verra plus loin.

Suivant la présente invention, les valeurs des courants $i_c$ et $i_d$ ainsi mesurées permettent d'obtenir une mesure de l'état de charge EDC de la batterie, en % de sa charge maximale, grâce à la relation qui existe entre cet état de charge et le logarithme du rapport $i_d/i_c$, illustrée par le graphe de la figure 2.

On établit cette relation, et ce graphe, par la procédure de mesure suivante. Partant d'une batterie complètement déchargée (EDC = 0%), on charge celle-ci à une valeur prédéterminée, par exemple à la valeur EDC = 10%. Une fois cet état de charge établi, on exécute la séquence de charge et décharge illustrée par les graphes de la figure 1 et on mesure alors les courants de charge $i_c$ et de décharge $i_d$ obtenus. On calcule ensuite $Log\frac{i_d}{i_c}$, ce qui permet d'obtenir un point du graphe de la figure 2.

Cette procédure est répétée pour des valeurs croissantes de EDC, jusqu'à 100%. L'ensemble des mesures ainsi obtenu est représenté par le graphe en "S" de la figure 2. Les mesures peuvent aussi être tabulées dans un calculateur programmé pour calculer $Log\frac{i_d}{i_c}$ et pour en déduire l'état de charge de la batterie, conformément au procédé de mesure suivant l'invention.

La forme en S du graphe de la figure 2 reflète le fait qu'à incrément $\Delta U_{f1}$ de tension constant, le courant $i_c$ est grand quand la batterie est vide et tend vers zéro quand elle est pleine. En ce qui concerne le courant $i_d$, c'est l'inverse, d'où l'évolution du rapport $i_d/i_c$, et donc du logarithme de ce rapport, illustrée par le graphe.

On tient compte de l'influence de la température en établissant la relation illustrée par la figure 2 pour diverses valeurs de cette température et en mesurant la température de la batterie à l'aide d'une sonde convenablement placée, pour choisir la relation utilisée dans la mesure de l'état de charge de la batterie.

Les tensions $U_f$, $\Delta U_{f1}$, $\Delta U_{f2}$ et les temps $t_c$, $t_d$ peuvent être choisis de manière à améliorer la précision de la mesure de EDC dans telle ou telle zone d'état de charge de la batterie. C'est ainsi que, par exemple, la tension $U_f$ peut être choisie en fonction de l'état d'usure de la batterie ou de sa tension à vide, mesurée avant la mise en oeuvre du procédé suivant l'invention, de mesure de son état de charge.

Ce procédé pourrait d'ailleurs comporter plusieurs séquences successives du type de celle décrite ci-dessus, mais en différant par l'ordre des charges et décharges, avec auto-adaptation progressive des paramètres fixant les niveaux des durées de ces charges et décharges, toujours pour améliorer la précision de la mesure de l'état de charge de la batterie.

Comme cela est évident pour l'homme de métier, le procédé suivant l'invention se prête tout particulièrement à être exécuté par des moyens intégrés à un chargeur de batterie, ce dernier possédant déjà tous les composants électroniques nécessaires à l'établissement des commutations de tension prévues par la présente invention. Un tel chargeur assure ainsi, outre sa fonction classique de charge, une fonction de mesure de l'état de charge. Les moyens à mettre en place dans le chargeur pour exécuter cette fonction supplémentaire sont immédiatement apparents pour l'homme de métier, à partir des seules informations données dans la présente description.

Dans un véhicule automobile, un calculateur de bord pourrait aussi être conçu pour commander l'exécution d'un programme de mesure de cet état de charge, suivant le procédé selon l'invention.

Il apparaît maintenant que l'invention permet bien d'atteindre les buts fixés, à savoir assurer une mesure de l'état de charge d'une batterie par des moyens simples et donc peu onéreux, néanmoins précis car largement dégagés des causes d'imprécision affectant les procédés de mesure d'état de charge connus de la technique antérieure.

Suivant l'invention, on détermine ainsi l'état de charge d'une batterie en se basant sur la faculté des électrodes de la batterie à accepter une charge et une décharge, et non sur la concentration en acide sulfurique de l'électrolyte de la batterie ou sur la tension disponible à ses bornes.

Le procédé suivant l'invention permet de s'affranchir des contraintes de temps de repos après une charge (évoquées plus haut) et donc de procéder à une mesure d'état de charge même si la batterie vient de subir une charge ou une décharge.

On a vu plus haut que $i_d$ croît alors que $i_c$ décroît quand la charge de la batterie augmente. Il en résulte une grande dynamique de mesure, de $10^8$ (soit de -4 à +4 en logarithme, voir figure 2). Une précision moyenne des mesures de $i_c$ et $i_d$ permet donc de mesurer l'état de charge avec une précision très suffisante.

En outre, les valeurs absolues des intensités des courants de charge et de décharge pour un même saut de tension ($\Delta U_{f1} = \Delta U_{f2}$) dépendent de la taille de la batterie mais restent proportionnelles entre la charge et la décharge. Ainsi l'utilisation, dans la mesure de l'état de charge, du rapport $i_d/i_c$ assure une mesure indépendante de la taille de la batterie. Un graphe moyen (pour une température moyenne donnée) pourrait donc être utilisé pour la mesure de l'état de charge suivant la présente invention.

Bien entendu la présente invention n'est pas limitée au mode de réalisation décrit et représenté. C'est ainsi que l'invention n'est pas limitée au procédé selon lequel on charge d'abord la batterie pour mesurer $i_c$ puis on la décharge pour mesurer $i_d$. On ne sortirait évidemment pas du cadre de la présente invention en inversant l'ordre de cette séquence de charge et décharge.

## Revendications

**1.** Procédé de mesure de l'état de charge (EDC) d'une batterie d'accumulateurs électriques, suivant lequel :

a) à partir d'une tension ($U_f$) prédéterminée établie au bornes de la batterie, on charge et on décharge ladite batterie à des tensions prédéterminées ($U_f + \Delta U_{f1}$) et ($U_f - \Delta U_{f2}$) respectivement, pendant des temps prédéterminés ($t_c$) et ($t_d$) respectivement,
b) à l'expiration des temps ($t_c$) et ($t_d$), on mesure les courants ($i_c$) et ($i_d$), de charge et de décharge, respectivement, et
c) on tire l'état de charge (EDC) de ladite batterie d'une relation préétablie liant $\text{Log}\dfrac{i_d}{i_c}$ audit état de charge (EDC).

**2.** Procédé conforme à la revendication 1, **caractérisé en ce qu'**on procède d'abord à la charge, puis à la décharge de ladite batterie.

**3.** Procédé conforme à l'une quelconque des revendications 1 et 2, **caractérisé en ce qu'**on établit ladite relation $\text{Log}\dfrac{i_d}{i_c} = f(EDC)$ pour diverses valeurs de la température de ladite batterie.

**4.** Procédé conforme à l'une quelconque des revendications 1 à 3, **caractérisé en ce que** $t_c = t_d$.

**5.** Procédé conforme à l'une quelconque des revendications 1 à 4, **caractérisé en ce que** $\Delta U_{f1} = \Delta U_{f2}$.

**6.** Procédé conforme à l'une quelconque des revendications 1 à 5, **caractérisé en ce que** ($U_f$) est choisie égale à une tension d'entretien de ladite batterie.

**7.** Procédé conforme à l'une quelconque des revendications 1 à 5, **caractérisé en ce que** ($U_f$) est choisie en fonction de la tension à vide de ladite batterie.

**8.** Chargeur de batterie d'accumulateurs électriques, **caractérisé en ce qu'**il comprend des moyens d'exécution du procédé de mesure conforme à l'une quelconque des revendications 1 à 7.

FIG.1

FIG.2